(19) Europäisches Patentamt
European Patent Office
Office européen des brevets

(11) **EP 2 417 076 B2**

(12) **NEUE EUROPÄISCHE PATENTSCHRIFT**
Nach dem Einspruchsverfahren

(45) Veröffentlichungstag und Bekanntmachung des Hinweises auf die Entscheidung über den Einspruch:
**27.05.2026   Patentblatt 2026/22**

(45) Hinweis auf die Patenterteilung:
**30.10.2019   Patentblatt 2019/44**

(21) Anmeldenummer: **10715496.5**

(22) Anmeldetag: **30.03.2010**

(51) Internationale Patentklassifikation (IPC):
*C03C 17/23* (2006.01)        *C03C 17/34* (2006.01)
*C03C 23/00* (2006.01)

(52) Gemeinsame Patentklassifikation (CPC):
**C03C 23/0025; C03C 17/002; C03C 17/23;
C03C 17/3411; C03C 23/007; C23C 14/086;
C23C 14/5806; C23C 14/5813; C23C 14/5873;
C23C 16/407; C23C 16/56; F27B 9/028;
F27B 9/066; F27D 99/0006;** C03C 2217/231;
(Forts.)

(86) Internationale Anmeldenummer:
**PCT/EP2010/002024**

(87) Internationale Veröffentlichungsnummer:
**WO 2010/115558 (14.10.2010 Gazette 2010/41)**

(54) **VERFAHREN UND SYSTEM ZUR HERSTELLUNG EINES BESCHICHTETEN GEGENSTANDS MIT TEMPERN**

METHOD AND SYSTEM FOR PRODUCING A COATED OBJECT BY TEMPERING

PROCÉDÉ ET SYSTÈME POUR PRODUIRE UN OBJET REVÊTU PAR TRAITEMENT THERMIQUE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität:   **09.04.2009   DE 102009017035
16.07.2009   DE 102009033417**

(43) Veröffentlichungstag der Anmeldung:
**15.02.2012   Patentblatt 2012/07**

(73) Patentinhaber: **INTERPANE Entwicklungs-und Beratungsgesellschaft mbH
37697 Lauenförde (DE)**

(72) Erfinder:
• **KAPPERTZ, Oliver**
  **33098 Paderborn (DE)**
• **MICHEL, Lars**
  **37671 Höxter (DE)**
• **DATZ, Marc**
  **37671 Höxter-Stahle (DE)**
• **WEIS, Hansjörg**
  **37671 Höxter (DE)**
• **HERLITZE, Lothar**
  **37691 Derental (DE)**

(74) Vertreter: **Körfer, Thomas
Mitscherlich PartmbB
Patent- und Rechtsanwälte
Karlstraße 7
80333 München (DE)**

(56) Entgegenhaltungen:
EP-A1- 1 962 295          WO-A1-2007/018975
WO-A1-2007/134439          WO-A1-2007/135874
WO-A1-2009/058385          WO-A1-2010/139908
WO-A2-2008/096089          DE-A1- 102006 005 019
DE-A1- 102007 009 924      DE-A1- 102007 052 782
DE-A1- 102008 001 578      US-A- 5 987 920
US-A1- 2003 224 162        US-A1- 2003 226 834
US-A1- 2004 148 969        US-A1- 2007 241 364
US-A1- 2009 098 351        US-B1- 6 533 966

• IMAY H ET AL: "ULTRAVIOLET-LASER-INDUCED CRYSTALLIZATION OF SOL-GEL DERIVED INDIUM OXIDE FILMS", JOURNAL OF SOL-GEL SCIENCE AND TECHNOLOGY, SPRINGER, NEW YORK, NY, US, vol. 13, no. 1 - 03, 1 January 1998 (1998-01-01), pages 991 - 994, XP000880428, ISSN: 0928-0707, DOI: 10.1023/A:1008604213960

EP 2 417 076 B2

- **GANZ D ET AL: "LASER SINTERING OF SNO2: SB SOL-GEL COATINGS", JOURNAL OF SOL-GEL SCIENCE AND TECHNOLOGY, SPRINGER, NEW YORK, NY, US LNKD- DOI:10.1023/ A:1008634902289, vol. 13, no. 1 - 03, 1 January 1998 (1998-01-01), pages 961 - 967, XP000880426, ISSN: 0928-0707**

(52) Gemeinsame Patentklassifikation (CPC): (Forts.)
C03C 2217/24; C03C 2217/241; C03C 2217/242;
C03C 2217/243; C03C 2217/244; C03C 2217/94;
C03C 2217/944; C03C 2217/948

**Beschreibung**

Die Erfindung betrifft ein Verfahren zur Herstellung eines beschichteten Gegenstands, wobei die Beschichtung sowohl transparent als auch leitfähig ist, und einen so hergestellten Gegenstand.

Transparente leitfähige Beschichtungen können in vielfältiger Weise eingesetzt werden. Von besonderer Bedeutung ist dabei die Funktion als transparente Frontelektrode in Dünnschicht-Solarzellen, sowie bei Flachbildschirmen. Andere Anwendungen beinhalten Kontakte für Elektrolumineszenzquellen, zur Ansteuerung von Flüssigkristallen, elektrochrome Beschichtungen, für transparente Heizelemente und Anti-Beschlag-Beschichtungen (englisch: antifogging). Zusätzlich sind bei entsprechendem Reflexionsvermögen im Infrarot Anwendungen im Bereich Radarentspiegelung, Wärmeschutz und Brandschutz möglich.

Die Herstellung dieser Beschichtung ist üblicherweise ausgesprochen aufwändig, um die widersprüchlichen Eigenschaften Transparenz und Leitfähigkeit zu vereinen. Insbesondere sind hohe Temperaturen des zu beschichtenden Gegenstands erforderlich. Gerade bei Vakuumbeschichtungsverfahren ist das Heizen während des Prozesses ein erhebliches Problem, dass nur mit hohen Kosten gelöst werden kann. Zusätzlich muss die Beschichtung für die Anwendung in Solarzellen eine bestimmte Rauhigkeit aufweisen, um eine ausreichende Lichtstreuung zu gewährleisten. Andererseits soll die Lichtstreuung für die anderen möglichen Anwendungen üblicherweise möglichst gering sein. Damit ist die Oberflächentextur nach Leitfähigkeit und Transparenz die dritte Schichteigenschaft, die gleichzeitig erfüllt sein muss.

Ein mögliches Vorgehen ist dabei, beispielsweise ein Glasband direkt nach der Herstellung noch bei ca. 600°C mit Zinnoxid zu beschichten. Hierbei werden alle drei Parameter gleichzeitig eingestellt; entsprechend bietet ein derartiger Prozess nur eingeschränkte Optimierungsmöglichkeiten.

Ein weiteres Verfahren besteht darin, Zinkoxid bei ca. 300°C in einer Vakuumbeschichtung aufzubringen, und die Oberflächentextur durch einen zusätzlichen Ätzschritt einzustellen. Das Problem hierbei besteht darin, das Substrat gleichmäßig und effizient aufzuheizen, sowie anschließend wieder kontrolliert abzukühlen, ohne dass es zu thermischen Brüchen kommt.

Aus der WO 2007/018975 A1 ist zwar das Tempern von TCO-Beschichtungen im Vakuum jedoch ohne Laser-Bestrahlung und ohne Verwendung eines Konvektionsofens bekannt.

Die WO 2008/096089 A2 offenbart im Beispiel 12 ein Verfahren zur Temperaturbehandlung einer TCO-Schicht aus Al-dotiertem ZnO mittels CO2-Laser. Die Druckschrift offenbart im Beispiel 2 auch die Behandlung mit Nd: YAG-Lasern, aber nur von Silber-Schichten und nicht von TCO-Schichten.

Der Artikel: IMAY H ET AL: "ULTRAVIOLET-LASER-INDUCED CRYSTALLIZATION OF SOL-GEL SCIENCE AND TECHNOLOGY, SPRINGER, NEW YORK, NY, US,Bd. 12, Nr. 1 - 03, 1. Januar 1998 (1998-01-01), Seiten 991-994, ISSN: 0928-0707, offenbart ein Verfahren zur Kristallisation einer Sol-Gel-Schicht aus ITO mittels Nd: YAG-Laser, wobei aber Wellenlängen im ultravioletten Bereich genutzt werden.

Die Aufgabe der vorliegenden Erfindung besteht darin ein Verfahren und ein System zur Herstellung eines beschichteten Gegenstands und einen solchen Gegenstand zu schaffen, das bzw. der die oben genannten Nachteile vermeidet, wobei dabei sowohl die elektrische Leitfähigkeit und die optische Transparenz des beschichteten Gegenstands eingestellt werden kann.

Die Aufgabe wird durch das erfindungsgemäße Verfahren mit den Merkmalen des Anspruch 1 und durch das erfindungsgemäße System mit den Merkmalen des Anspruchs 16 gelöst. In den Unteransprüchen sind vorteilhafte Weiterbildungen des erfindungsgemäßen Verfahrens und des Systems dargestellt.

Die Erfindung basiert auf einer vollständigen Trennung der einzelnen Prozessschritte Aufbringen der Beschichtung bei niedrigen Substrattemperaturen, Einstellen der elektrischen Leitfähigkeit und der optischen Leitfähigkeit durch eine Temperaturbehandlung und ein Verfahren hierfür, sowie optional das Einstellen der Oberflächentextur in einem Ätzschritt. Das Aufbringen der Beschichtung wird bei einer Substrattemperatur von höchstens 180°C, weiter bevorzugt höchstens 160°C, noch weiter bevorzugt höchstens 150°C, insbesondere bevorzugt höchstens 130°C vorgenommen. Dies kann beispielsweise erreicht werden, wenn auf eine zusätzliche Aufheizung des Substrats vor Beginn der Abscheidung verzichtet wird.

Der wichtigste physikalische Parameter des erfindungsgemäßen Verfahrens zur Einstellung der elektrischen Leitfähigkeit und der optischen Transparenz durch eine nachfolgende Temper-Behandlung ist die Temperatur T. Es stellt sich heraus, dass die Temperaturbehandlung besonders effektiv mittels Laserstrahlung erfolgen kann. Durch diesen Ansatz kann die Temperaturbehandlung sowohl an Umgebungsluft als auch im Vakuum erfolgen.

Als besonders vorteilhaft stellt sich eine Strahlgeometrie heraus, bei der durch entsprechende Optiken der Laserstrahl als schmale Linie ausgeführt ist. Diese Linie wird z.B. von gekoppelten Er:YAG-Laser oder Ho:YAG-Laser oder Yb:YAG-Laser z.B. als Stab- oder Scheiben- Laser erzeugt, bei deren bzw. dessen Wellenlänge die Schicht absorbierend ist. Eventuell muss die Frequenz verdoppelt werden.

Die erfindungsgemäße Laserbehandlung in einer erfindungsgemäßen Laserbestrahlungsvorrichtung bewirkt dabei eine Verbesserung der Leitfähigkeit der Beschichtung, wobei gleichzeitig die Transparenz im Sichtbaren verbessert wird. Diese Verbesserungen sind so deutlich, dass es mit diesem Verfahren möglich ist, die Schichten kalt abzuscheiden, was üblicherweise zu geringen Ladungsträgerkonzentrationen und Ladungsträgerbeweglichkeiten bei gleichzeitig schlechter Transparenz führt, und durch diese Nachbehandlung Schichteigenschaften vergleichbar zu heiß abgeschiedenen Schichten zu erzielen.

Eine andere Methode der Temperaturbehandlung wird das Erhitzen in einem Hochkonvektionsofen durch Ventilatoren und Heizstrahler oder in einem Zweikammerofen durch Heißluftgebläse und Heizstrahler bevorzugt außerhalb eines Vakuums angewendet. Der Hochkonvektionsofen sowie der Zweikammerofen haben den Vorteil, dass die Beschichtung und das Substrat, wobei auch in dieser Variante bevorzugt Glas als Substrat verwendet wird, sehr gleichmäßig, das heißt sehr homogen erhitzt wird. Vorteilhaft erübrigt sich bei einem Hochkonvektionsofen und auch bei einem Zweikammerofen die Schaffung eines Vakuums, da die Wärmeübertragung durch Konvektion geschieht.

Es können je nach Schichtmaterial und Dotierung spezifische Widerstände zwischen $80\mu\Omega cm$ und $5000\mu\Omega cm$ eingestellt werden. Je nach Anwendung sind Schichtwiderstände z.B. zwischen $1\Omega_{sq}$ und $500\Omega_{sq}$ möglich, was abhängig von Grundmaterial und Dotierung Schichtdicken zwischen 30nm und $2\mu m$ entspricht.

Die Metalloxidschicht besteht im Wesentlichen zum Beispiel aus Zinkoxid, Cadmiumoxid, Zinnoxid, Indiumoxid oder aus Mischungen von zwei oder mehrerer dieser Oxide. Vorzugsweise werden die Metalloxidschichten dotiert.

Die folgende Aufzählung enthält beispielhaft verwendete Metalloxide und ihre Dotierungen. Bei den Metalloxidschichten gibt es prinzipiell zwei Typen: n-dotierte und p-dotierte Schichten.

Als n-dotierte Schichten werden die folgenden Verbindungen verwendet:
Indiumzinnoxid (ITO) oder eine Verbindung der Struktur II-VI:III, wobei

II für Zn, Cd, Hg, Be, Mg, Ca, Sr, Ba,
III für B, Al, Ga, In, Sc, Y, La...Lu, Cr, Mo, W
und IV für einatomigen Sauerstoff steht, wobei insbesondere ZnO:Al, ZnO:Ga, ZnO:B eingesetzt werden, oder eine Verbindung der Struktur
IV-VI$_2$:V, wobei
IV für Sn, Pb, Ti, Zr, Hf,
VI für O, S, Se,
und V für V (Vanadium), Nb, Ta, P, As, Sb
steht. Insbesondere werden bei dieser Struktur SnO$_2$:Sb und TiO$_2$:Nb verwendet. Auch ist eine Dotierung mit VII an Platz von VI möglich, wobei VII F oder Cl sein kann.

Bei den p-Typen kommen die folgenden Verbindungen zum Einsatz:

IV-VI$_2$:III, also insbesondere TiO$_2$:Cr,
I-III-VI$_2$ mit I = Cu, Ag, (Au), Li, insbesondere CuAlO$_2$, CuCrO$_2$ mit jeweils komplexen Dotierungsmöglichkeiten,
-I$_2$-II-IV-VI$_4$, insbesondere Cu$_2$ZnSnO$_4$ mit ebenfalls komplexen Dotierungsmöglichkeiten. Auch ist eine Dotierung mit V an Platz von VI möglich, wobei V hier für N oder P steht.

Es kann eines oder mehrere der Elemente S, Se, Ca, Mg, Sr vorhanden sein, um die Lage der Valenz- und Leitungsbänder und damit auch die optische Bandlücke zu kontrollieren. Die Konzentration dieser zusätzlichen Elemente liegt bevorzugt zwischen 2at.% und 20at.%.

Die Ladungsträgerkonzentration und damit die elektrische Leitfähigkeit wird über die Zugabe von Dotierelementen wie Al, aber auch B, Ga, In, F, Cl, P, As, Sb eingestellt. Dabei werden bevorzugt Zinkoxid mit Al und Zinnoxid mit F dotiert. Bei einem Indium-dotierten Zinnoxid, betragen bevorzugt die Stoffanteile von Indium 60% bis 95%, besonders bevorzugt 90%, und von Zinn 5% bis 40%, besonders bevorzugt 10% (in at.%). Dieses Indium-dotierte Zinnoxid ist intrinsisch leitfähig. Die Konzentration der Dotierelemente zur Einstellung der elektrischen Leitfähigkeit beträgt zwischen 0,1at.% und 10at.%, bevorzugt zwischen 0,2at.% und 6at.%, besonders bevorzugt zwischen 0,4 at.% und 3 at.%, bezogen auf den Metallgehalt.

Nachfolgend wird die Erfindung an Ausführungsbeispielen beispielhaft beschrieben. Es zeigen:

Fig.1        das erfinderische Herstellungsverfahren im Überblick;
Fig.2        den ersten erfindungsgemäßen Verfahrensschritt am Beispiel einer Sputtervorrichtung;
Fig.3        einen beispielhaften erfinderischen Schichtaufbau;
Fig.4a-4c    eine schematische Darstellung des erfindungsgemäßen zweiten Verfahrensschritts der Temperaturbehandlung durch eine Laserbestrahlungsvorrichtung;
Fig.5a-5b    eine schematische Darstellung eines erfindungsgemäßen Laserbeleuchtungsmoduls und einer daraus erzeugten Laserlinie;
Fig.6        einen Hochkonvektionsofen;

Fig.7 die Temperaturbehandlung als Verfahrensschritt in einem Hochkonvektionsofen;

Fig.8 einen Zweikammerofen;

Fig.9 die Temperaturbehandlung als Verfahrensschritt in einem Zweikammerofen;

Fig.10 den optionalen Ätzschritt und

Fig.11a-c die Temperaturbehandlung durch einen gepulsten Yb:YAG/Scheibenlaser im Scan-Modus.

Die Bezugzeichen in allen Figuren sind konsistent gehalten, so dass jedes Teil in allen Figuren das gleiche Bezugzeichen trägt. Zunächst werden die Figuren im Einzelnen beschrieben. Danach folgen zwei erfindungsgemäße Ausführungsbeispiele.

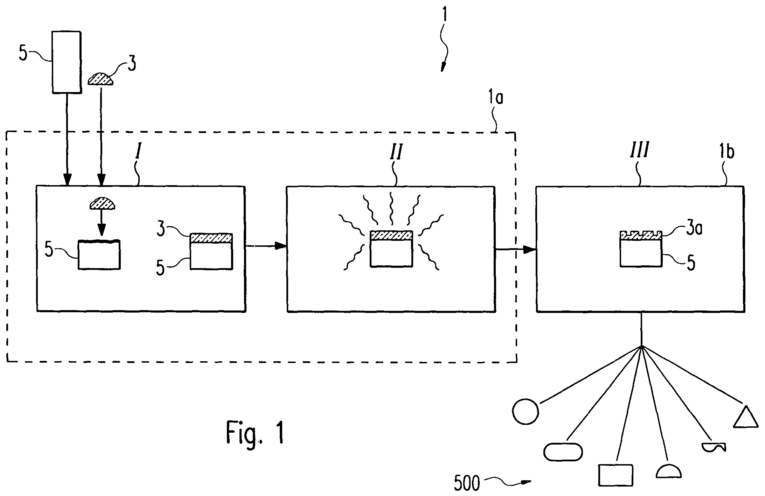

In Fig. 1 ist das erfindungsgemäße Verfahren zur Herstellung eines beschichteten Gegenstands 2 mit seinen zwei bzw. drei Verfahrensschritten I Beschichten, II Erhitzen und III Ätzen dargestellt. Dabei bilden die beiden ersten Verfahrensschritte I, II im gestrichelten Kasten 1a die erfindungsgemäße Lösung und optional kann sich an die beiden Verfahrensschritte I und II ein Verfahrensschritt III - das Ätzen - anschließen. Links oben sind die Ausgangmaterialien, das Beschichtungsmaterial 3 und dessen Träger, das sogenannte Substrat 5, welches bevorzugt aus Glas besteht, abgebildet.

Die Beschichtungsmaterialien sind ein oder mehrere Metalloxide, sogenannte TCOs, transparente, elektrisch leitfähige Oxide. (transparent, conductive oxides). Im Verfahrensschritt I wird das Substrat 5 mit ein oder mehreren Metalloxiden beschichtet. Im Verfahrensschritt II wird das beschichtete Substrat 2 durch eine Temperaturbehandlung erhitzt, um die elektrische Leitfähigkeit und die optische Transparenz der Beschichtung 3 einzustellen, und im optionalen Verfahrensschritt III wird die Beschichtung 3 einer Ätzung zur Bildung einer Oberflächentextur 3a unterzogen.

Wichtig ist dabei, dass die Verfahrensschritte I, II und III alle streng voneinander getrennt sind. Das Resultat aus den Verfahrensschritten I, II und dem optionalen Verfahrensschritt III ist ein beschichteter Gegenstand 2 für eine vielfältige Palette von Endprodukten 500, wie zum Beispiel Dünnschichtsolarzellen, Autoglasscheiben, die nicht beschlagen, radarentspiegelte Verkleidungen für Flughafengebäude usw..

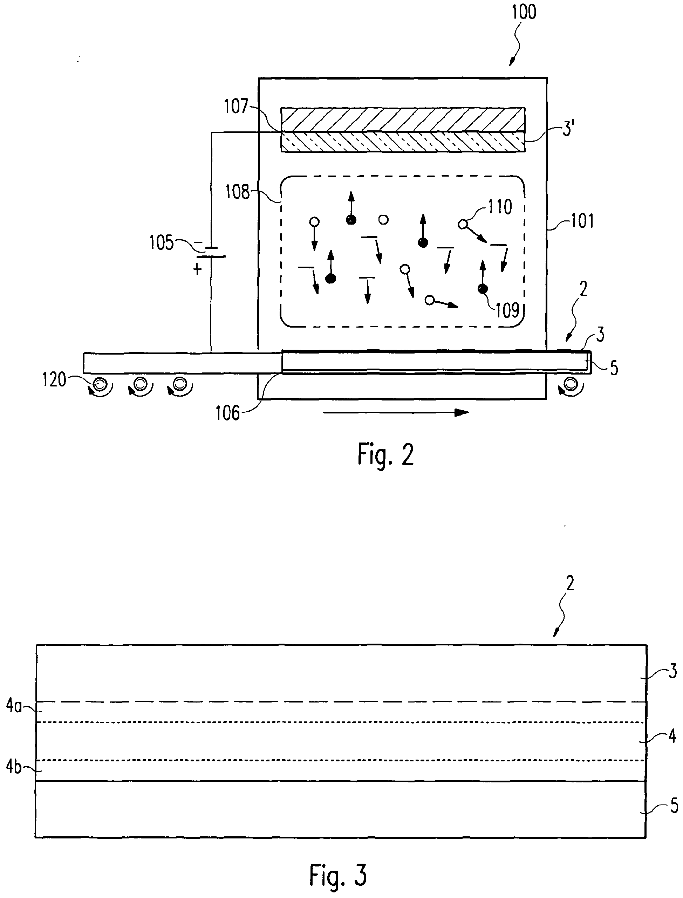

Fig. 2 zeigt eine beispielhafte Beschichtungsvorrichtung in Form einer Sputteranlage 100, bestehend aus einer Vakuumkammer 101 einer Spannungsversorgung 105, einer Anode 106, die hier durch das Substrat 5 verdeckt ist, und einer Kathode 107. In der Vakuumkammer 101 werden einem Festkörper 3'als Target, der aus einem transparenten, leitfähigen Metalloxid besteht, durch Beschuss mit energiereichen Ionen 109, die in einem elektrischen Feld, das die Anode 106 und die Kathode 107 bilden, beschleunigt werden, Atome bzw. Moleküle 110 herausgelöst. Diese Atome bzw. Moleküle 110 scheiden sich an der Oberfläche eines Substrats 5, das z.B. als Glasscheibe auf Walzen 120 mit konstanter Geschwindigkeit durch die Vakuumkammer 101 bewegt wird, ab. Diese Atome 110 bilden dann eine Beschichtung 3. Mit dieser Gasphasenabscheidung können ein oder mehrere Schichten auf das Substrat 5 aufgetragen werden.

Wenn das Targetmaterial selbst aus einem Festkörper 3' aus reinem Metall, also ohne Oxide besteht, kann das sogenannte reaktive Sputtern eingesetzt werden. Beim reaktiven Sputtern entsteht die Beschichtung 3 durch eine chemische Reaktion der aus dem Target 3' herausgelösten Atome, also Atome eines der vorgenannten Metalle mit einem Reaktionsgas, hier Sauerstoff, um eine Oxidschicht 3 auf der Oberfläche des Substrats 5 zu erzeugen. Die chemische Reaktion bei Zink mit Sauerstoff ist

$$2Zn + yO_2 \rightarrow 2ZnO_y,$$

wobei sich auf dem Substrat 5 eine Zinkoxidschicht 2 bildet, die bevorzugt etwas substöchiometrisch ist, d.h $y<1$. Auf diese Weise können auch mehrere Schichten verschiedener Metalloxide durch hintereinander ausgeführtes reaktives Sputtern aufgetragen werden.

Fig. 3 zeigt ein Beispiel für eine erfindungsgemäße Beschichtung. Diese Beschichtung besteht aus 4 Schichten, welche von oben nach unten folgendermaßen angeordnet sind: Eine TCO-Schicht 3, die selbst wiederum aus mehreren TCO-Schichten verschiedener TCOs aufgebaut sein kann, einer Interferenzschicht 4a, einer Diffusionssperre 4 und eine weitere Interferenzschicht 4b. Die Diffusionssperre 4 kann auch selbst als Interferenzschicht ausgebildet sein.

Nun werden die Funktionen der Schichten 4a, 4 und 4b erklärt. Zur Verhinderung von Elektrokorrosion ist zwischen der TCO-Schicht 3 und dem Substrat 5 die Natrium-Diffusionssperre 4 eingefügt, so wie dies in Fig. 3 dargestellt ist. Die Dicke der Diffusionssperrschicht 4 beträgt dabei zwischen 5nm und 200nm, bevorzugt zwischen 10nm und 50nm. Besonders bieten sich Siliziumoxid, Siliziumnitrid, Siliziumcarbid, sowie Mischungen und/oder Verbindungen zweier oder aller dieser Substanzen an. Dabei ist eine leichte Abweichung von der stöchiometrischen Zusammensetzung vorteilhaft. Diese sollten jedoch bevorzugt in Summe 10% nicht überschreiten, da sonst die Absorption der Diffusionssperre 4 zu hoch wird. Insgesamt sollte die Absorption dieser Teilschicht 2% nicht überschreiten. Dieser Wert berechnet sich als Differenz der Summen aus Lichttransmission und -reflexion bei einer Wellenlänge von 515nm für jeweils das Schichtsystem ohne und mit dieser Diffusionssperre 4.

Zusätzlich zur Diffusionssperrwirkung erfolgt eine Entspiegelung durch destruktive Interferenz von an zwei verschiedenen Schichtgrenzen reflektierten Lichtwellenzügen der Wellenlänge A mit dem Gangunterschied A/2: Eine sogenannte Interferenzentspiegelung. Dazu kann sowohl zwischen Diffusionssperrschicht 4 und TCO-Schicht 3 die Interferenzschicht 4a eingefügt werden als auch zwischen der Diffusionssperrschicht 4 und Substrat 5 eine entsprechende Interferenzschicht 4b eingefügt werden, wie in Fig.3 gezeigt. Die Dicke der Interferenzschichten 4a bzw. 4b betragen zwischen 20nm und 100nm. Die Interferenzschichten 4a, 4b wirken entspiegelnd. Bevorzugte Materialien sind Oxide, Nitride und Carbide von Silizium, Aluminium, Zink, Zinn, Titan, Zirkon, Hafnium, Vanadium, Niob, Tantal, sowie Mischungen zweier oder mehrerer dieser Substanzen. Es ist auch möglich, die Diffusionssperrschicht 4 selbst als Interferenzschicht auszubilden.

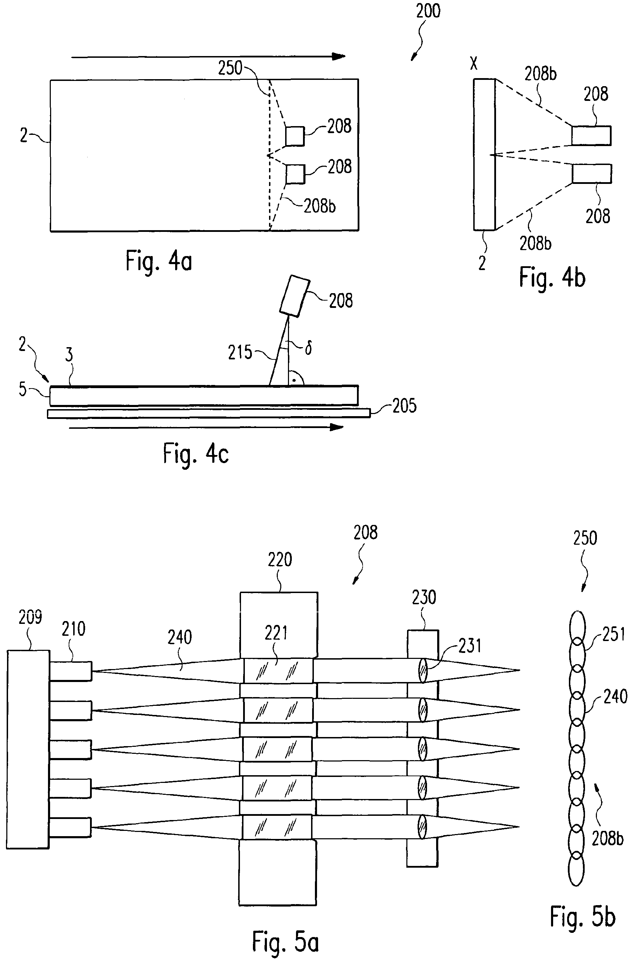

Die Figuren 4a, 4b und 4c, zeigen sehr schematisch eine beispielhafte Temperaturbehandlungsvorrichtung in Form einer Laserbestrahlungsvorrichtung 200, die den Substratkörper auf eine Temperatur $T_{IIa}$ erhitzt. Dabei zeigt Fig. 4a einen beschichtete Substratkörper 2 in Form einer rechteckigen Platte, die mit konstanter Geschwindigkeit $v_{IIa}$ in Pfeilrichtung bewegt wird, in einer Draufsicht. Über dem Substratkörper 2 sind zwei Laserbeleuchtungsmodule 208 angebracht, welche zwei Beleuchtungsbereiche 208b, eingezeichnet durch gestrichelte Linien, erzeugen, deren Licht in Form einer Laserlinie 250 fast senkrecht auf die Beschichtung 3 des Substratkörpers 2 auftrifft. Die Beschichtung 3 wird durch das Laserlicht erhitzt. Die Laserlinie 250 steht senkrecht zur Bewegungsrichtung der Substratkörpers 2.

Die Lasermodule sind so angeordnet, das die erzeugten linienförmigen Beleuchtungsbereiche 208b nebeneinander angeordnet zusammen den Substratkörper in seiner gesamten Breite erfassen. Alternativ ist es auch möglich, dass bereits jeder einzelne linienförmige Beleuchtungsbereich 208b den Substratkörper in seiner gesamten Breite erfasst.

Fig. 2b zeigt die Bestrahlung des Substratkörpers 2 durch zwei Laserbeleuchtungsmodule 208 in der Frontansicht. Die Abbildungsebene steht also senkrecht zur Bewegungsrichtung des Substratkörpers 2. Auch hier wird deutlich, dass beide Laserbeleuchtungsmodule 208 nebeneinander angeordnet zusammen die gesamte Substratkörperbreite erfassen.

Fig. 2c zeigt die Bestrahlung des Substratkörpers 2 in einer Seitenansicht. Der Laserstrahl 215 steht nicht ganz senkrecht zur beschichteten Oberfläche des Substratkörpers 2, um das Laserbeleuchtungsmodul 208 vor Selbstreflexionen am Substratkörper 2 zu schützen. Um dies zu verdeutlichen, ist der Winkel $\delta$ übertrieben groß dargestellt. Die Summe der Beleuchtungsbereiche 208b bildet immer eine scharfe Laserlinie, unter der der Substratkörper 2 entlang seiner gesamten Länge mit konstanter Geschwindigkeit $v_{IIa}$ auf einer Transporteinrichtung 205 bewegt wird.

Fig. 5a zeigt ein beispielhaftes Laserbeleuchtungsmodul 208, das jeweils einen Beleuchtungsbereich 208b erzeugt, der im Querschnitt eine scharfe Laserlinie 250 erzeugt, wie sie in Fig. 5b dargestellt ist. Mehrere Laser 210 sind im Ausführungsbeispiel auf einer Fixiervorrichtung 209 fixiert und sind im Ausführungsbeispiel zueinander parallel auf einer Geraden äquidistant ausgerichtet. Das Laserlicht, das die Laser 210 emittieren, läuft durch einen Kollimator 220, der Zylinderlinsen 221 beinhaltet, die das Laserlicht lateral begrenzen und parallelisieren. Dann trifft das parallelisierte Laserlicht auf einen Mikrolinsenarray 230, das durch seine asphärischen Linsen 231 das Laserlicht auf eine Laserlinie 250 fokussiert, wie in Fig. 5b dargestellt ist.

In Fig. 5a sind der Übersichtlichkeit wegen nur fünf fokussierte Laserstrahlen eingezeichnet. In Wirklichkeit stehen diese Laserstrahlen viel enger nebeneinander, so dass ihre Strahlkegel 240 einander überlappen, wie es in Fig. 5b gezeigt ist. Fig. 5b zeigt die Laserlinie 250 stark vergrößert gegenüber Fig. 5a. Die Strahlkegel 240 sind bedingt durch die asphärischen Linsen 231 im Querschnitt ellipsenförmig, wobei sich die Ellipsen 251 mit ihren langen Halbachsen alle entlang der Laserlinie 250 befinden. Die Ellipsen 251 überlappen sich dabei auf der Laserlinie 250. Jede einzelne Ellipse 251 entspricht im Querschnitt dabei einem durch eine asphärische Linse 231 des Mikrolinsenarrays 230 fokussiertem Laserlicht. Dabei muss nicht zwingend einer Ellipse 251 ein bestimmter Laser 210 zugeordnet sein. Die Breite der Laserlinie 250 ist sehr klein gegenüber der Länge der Laserlinie 250. Das Verhältnis beträgt bevorzugt mindestens 1 zu 100.

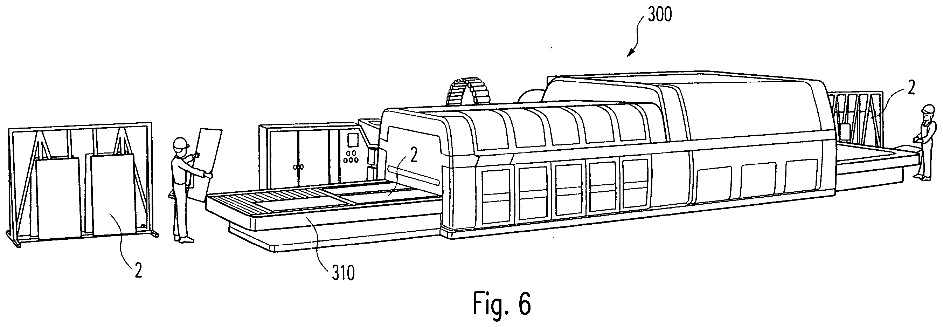

Die Fig. 6 zeigt einen Hochkonvektionsofen 300 als Möglichkeit der Temperaturbehandlung. Das beschichtete Substrat 2 wird in Form von rechteckigen Platten auf Laufwalzen 310 oder Laufbändern 310 dem Hochkonvektionsofen 300 mit konstanter geradliniger Geschwindigkeit $v_{IIb}$ zugeführt. Durch Konvektion wird die Substratschicht 3 des Substrats 5 auf eine bestimmte Temperatur $T_{IIb}$ erhitzt. Die Temperatur $T_{IIb}$ wirkt auf den Substratkörper 2 für eine bestimmte Zeit $\Delta t$ ein. Der erhitzte Substratkörper 2 verlässt daraufhin den Hochkonvektionsofen 300.

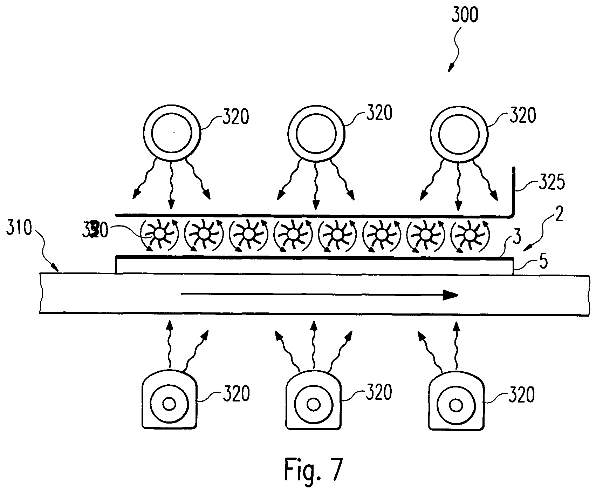

Fig. 7 zeigt den Verfahrensschritt im Hochkonvektionsofen 300 näher. Der mit konstanter Geschwindigkeit $v_{IIb}$ auf einem Transporteinrichtung 310, etwa einem Laufband oder Laufwalzen, bewegte Substratkörper 2 wird durch Heizstrahler 320 erhitzt. Mindestens ein Ventilator 330 sorgt für eine gleichmäßige Durchmischung der erhitzten Luft. Die Beschichtung 3 und das Substrat 5 werden durch die Konvektion auf eine bestimmte Temperatur $T_{IIb}$ aufgeheizt. Dabei verteilt ein Heizblech 325 die Heizstrahlung der Heizstrahler 320 gleichmäßig entlang der Laufrichtung und sorgt somit zusätzlich für eine homogene Erhizung der Beschichtung 3.

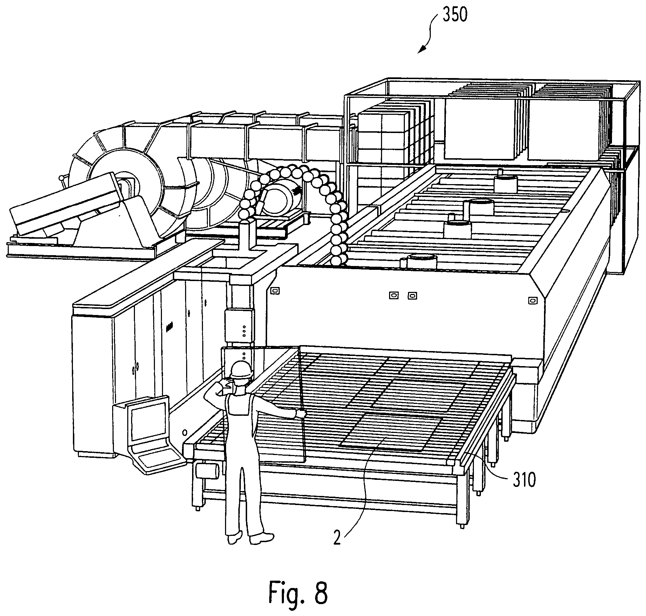

Die Fig. 8 zeigt einen Zweikammerofen 350 oder Mehrkammerofen oder Mehrzonenofen als Möglichkeit der Temperaturbehandlung. Das beschichtete Substrat 2 wird in Form von rechteckigen Platten auf Laufwalzen 310 oder Laufbändern 310 einer ersten Kammer des Zweikammeroffen 300 mit konstanter geradliniger Geschwindigkeit $v_{IIc}$ zugeführt. Durch Konvektion wird die Substratschicht 3 des Substrats 5 in der Zeit $\Delta t$ auf eine erste Temperatur gleichmäßig erhitzt. Danach wird der Substratkörper auf der Transporteinrichtung in eine zweite Kammer transportiert. In der zweiten Kammer wird der Substratkörper durch Konvektion und Strahlung in der Zeit $\Delta t$ auf eine zweite Temperatur gleichmäßig erhitzt.

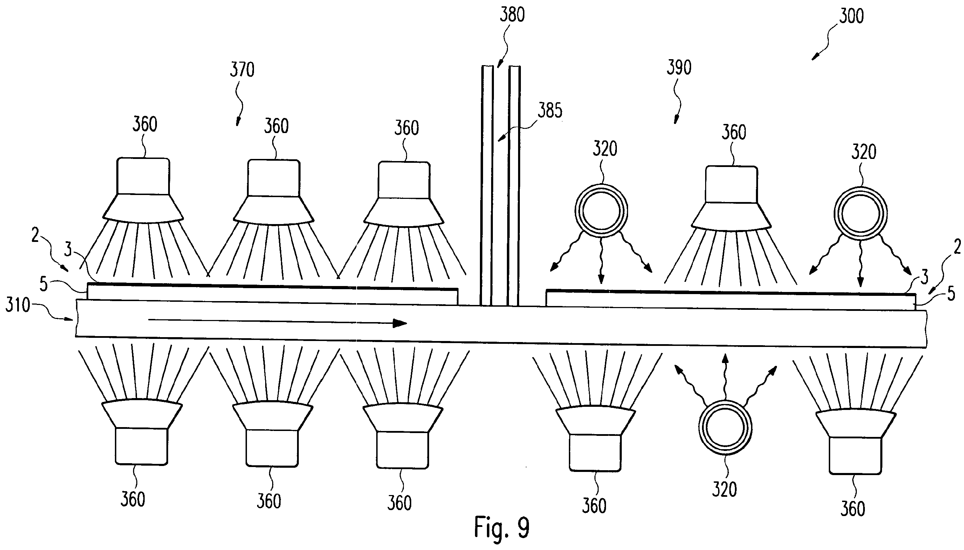

Fig. 9 zeigt den Verfahrensschritt im Zweikammerofen 300 näher. Der mit konstanter Geschwindigkeit $v_{llc}$ auf einer Transporteinrichtung 310, wie z.B. ein Laufband oder Laufwalzen, bewegte Substratkörper 2 wird in der ersten Kammer 370 durch mindestens ein Heißluftgebläse 360 gleichmäßig erhitzt. Die Beschichtung 3 und das Substrat 5 werden durch die Konvektion in der Zeit $\Delta t$ auf eine bestimmte Temperatur zwischen 350°C und 550°C aufgeheizt. Danach öffnet sich das linke Schott 380 und das Substrat gelangt in eine Schleusenkammer 385. Die Schleusenkammer trennt die erste Kammer 370 von der zweiten Kammer 390 zur thermischen Isolierung, denn in den Kammern 370 und 390 sollen unterschiedliche Temperaturen herrschen.

Zwischen den beweglichen Schotten 380 befindet sich eine Zwischenkammer 385. In Fig. 9 ist der Abstand aus Platzgründen kleiner gezeichnet. Das linke Schott 380 schließt sich und das rechte Schott öffnet sich daraufhin. Danach wird das Substrat auf Laufwalzen in die zweite Kammer 390 des Zweikammerofens 350 geschickt.

In der zweiten Kammer 390 wird das Substrat durch mindestens ein Heißluftgebläse 360 und mindestens einem Heizstrahler 320 in der Zeit $\Delta t$ auf eine Temperatur zwischen 500°C und 650°C, bevorzugt zwischen 620°C und 625°C, gleichmäßig aufgeheizt. Der erhitzte Substratkörper 2 verlässt daraufhin den Zweikammerofen 300.

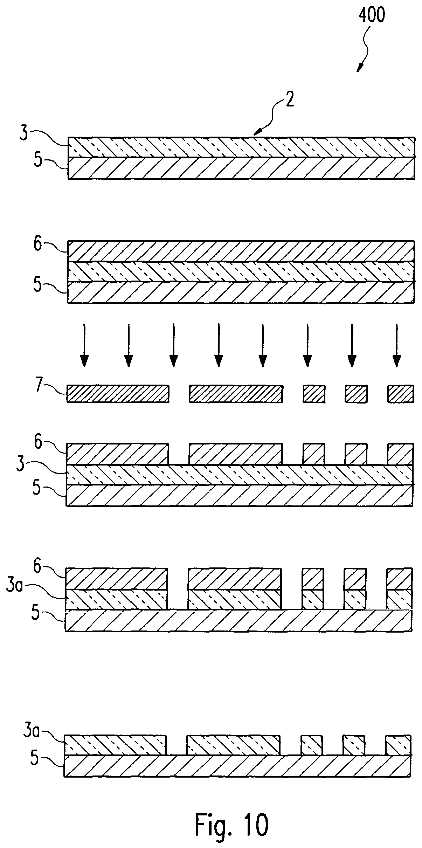

Fig. 10 zeigt den Ätzschritt III in Teilschritten von oben nach unten. Der Substratkörper 2 ist im vorangegangenen Verfahrensschritt II temperaturbehandelt worden.

Nun wird die Oberfläche des Substratkörpers 2 mit einer Säure, bevorzugt verdünnte Salzsäure, in Kontakt gebracht. Die Salzsäure ätzt homogen über das gesamte Substrat verteilt eine Aufrauhung in die Oberfläche. Die aufgeraute Oberfläche des Substrats hat nun das gewünschte optische Streuverhalten zum Beispiel für Dünnschicht-Solarzellen.

Siehe dazu in Fig. 8 nur die oberste und die unterste der sechs Teilzeichnungen.

Um komplexere Strukturen in die Oberfläche des Substratkörpers 2 zu ätzen, wird die Fotolithographie angewendet. Dabei wird zuerst auf die inzwischen abgekühlte Beschichtung 3 eine Fotoschicht 6 aufgetragen. Danach wird die Fotoschicht 6 durch eine Maske 7 hindurch belichtet, wodurch nur an den Stellen, an den die Maske 7 das Licht durchlässt, die Fotoschicht 6 auf der Beschichtung 3 verschwindet und diese dadurch wieder freilegt. Danach schließt sich das eigentliche Ätzen an, wobei bevorzugt verdünnte Salzsäure oder Flusssäure in die Beschichtung 3 eine Oberflächentextur 3a ätzt und zwar nur an den Stellen ohne Fotoschicht. Danach werden noch die Reste der Fotoschicht 6 entfernt. Bevorzugt wird auch das Ätzen III im Durchlaufverfahren durchgeführt. Siehe dazu alle sechs Teilzeichnungen in Fig. 8.

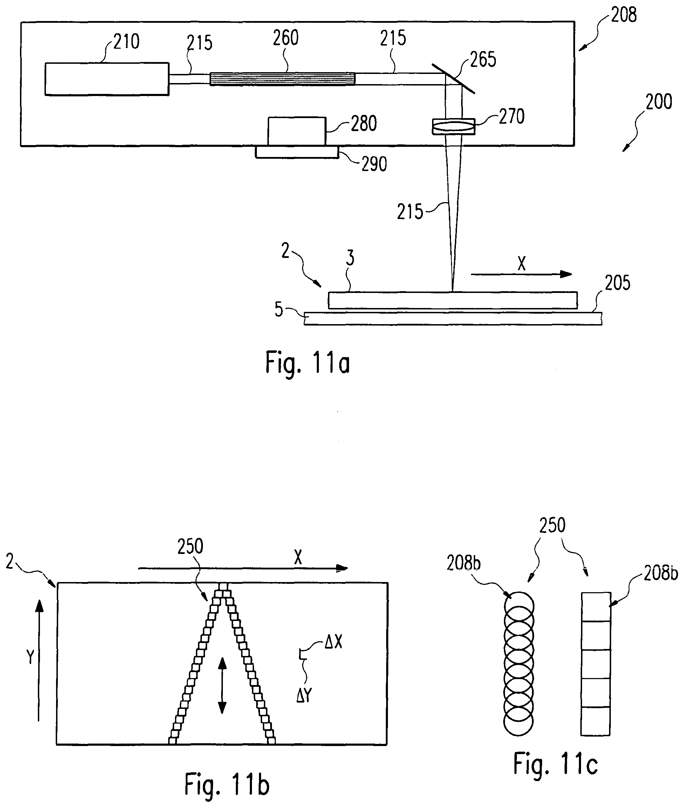

Die Figuren 11a, 11b und 11c zeigen eine alternative Temperaturbehandlung der Beschichtung 3 des Substratkörpers 2 mit einem gepulsten Yb:YAG/Scheibenlaser 210. Dies ist eine Alternative zu der Lasertemperaturbehandlung mit mehreren gekoppelten Lasern, die im ersten Ausführungsbeispiel beschrieben ist. Das Laserbeleuchtungsmodul 208 besteht hier aus einem Yb:YAG/Scheibenlaser 210, einer Glasfaseroptik 260, optional aus einem Umlenkspiegel 265, einem Fokussiermodul 270 und eine durch einen Motor 280 angetriebene Transporteinrichtung 290, die das Laserbeleuchtungsmodul 208 quer zur Bewegungsrichtung des Substratkörpers 2 gerade hin und her bewegt und so eine Laserlinie 250 auf der Substratoberfläche erzeugt. Siehe dazu Fig.11a und Fig.11b.

Der Yb:YAG/Scheibenlaser 210 ist ein Festkörperlaser, bei welchem das aktive Medium (der Laser-Kristall) die Form einer Scheibe hat. Der Laserstrahl 215 wird durch mehrfache Durchgänge einer Pumpstrahlung durch die Laserscheibe erzeugt. Einer der Resonatorspiegel ist an der Rückseite der Kristallscheibe aufgedampft, der andere Spiegel ist der Auskoppelspiegel und befindet sich in einiger Entfernung zur Scheibe. Vorteil dieser Form des Lasers ist die bessere Kühlung des Laserkristalls. Dieser ist mit der verspiegelten Fläche auf eine Wärmesenke geklebt und unterliegt wegen der Wärmeableitung über eine gesamte Grundfläche der Laserscheibe nur geringen mechanischen Spannungen, wodurch eine gute Fokussierbarkeit im Vergleich zu anderen Hochleistungs-Festkörperlasern erreicht wird. Typisches Kristallmaterial ist hoch Ytterbium-dotiertes YAG (Yttrium-Aluminium-Granat) beim sogenannten Yb:YAG-Laser mit einer Emissionswellenlänge von 1030 nm.

Zum Unterschied zu der in Fig.5a-b beschriebenen Erzeugung der Laserlinie 250, bei der die Laserlinie 250 durch mehrere Laser 210 gleichzeitig gebildet wird, wird hier die Laserlinie 250 durch einen Yb:YAG/Scheibenlaser 210 erzeugt, dessen gepulster Laserstrahl 215, der durch eine Glasfaseroptik 260, z.B. ein Laserlichtkabel, geführt wird, beispielsweise umgelenkt durch einen Spiegel 265 und fokussiert durch ein Fokussiermodul 270, senkrecht zur Bewegungsrichtung x, also in y-Richtung des Substratkörpers 2 über dessen gesamte Breite linear hin- und herbewegt wird. Siehe dazu Fig. 11a und Fig. 11b. Die Bewegung des Laserbeleuchtungsmoduls 208 erfolgt in Fig. 11a senkrecht zur Zeichenebene durch eine mit einem Motor 280 angetriebene Transporteinrichtung 290, etwa einer Rollschiene.

Dabei kann der Beleuchtungsbereich 208b, d.h. der Laserstrahl-Fokus, auf der Substratoberfläche 3 kreisförmig oder rechteckig sein, wie in Fig.11c zu sehen ist. Ein kreisförmiger Laserstrahl-Fokus ist konventionell und daher leicht zu erzeugen, hat aber den Nachteil, dass man mit nebeneinandergesetzten Kreisen eine ebene Oberfläche nicht flächendeckend parkettieren kann. Es bleiben Lücken auf der Substratoberfläche. Um diese Lücken zu vermeiden, muss man in diesem Fall den Laserstrahl 215 so bewegen, dass sich die Kreise auf der Substratoberfläche überlappen und für eine möglichst gleichmäßige Abdeckung der Substratoberfläche sorgen. Siehe dazu die Fig. 11c.

Eine andere Möglichkeit ist es, den Laserstrahl 215 im Laserbeleuchtungsmodul 208 optisch so zu führen, dass der Laserstrahl-Fokus ein Rechteck bildet, womit eine lückenlose Überdeckung durch eine nahezu schachbrettartige Parkettierung der Beschichtung 3 möglich ist. Eine deckende Parkettierung mit Rechtecken kann schneller erfolgen als eine deckende Parkettierung (bei gleicher Scangeschwindigkeit) mit flächengleichen Kreisen, die ja zur Deckung erst noch überlappt werden müssen. Siehe auch dazu die Fig. 11c. Den rechteckigen Laserfokus kann man durch eine Führung des Laserstrahls 215 durch eine Glasfaseroptik 260 erzielen, deren Glasfasern am Ende einen rechteckigen Querschnitt aufweisen. Dieser im Querschnitt rechteckige Laserstrahl 215 kann dabei umgelenkt werden durch einen Spiegel 265 und fokussiert werden durch ein Fokussiermodul 270. Siehe dazu Fig. 11a.

Da die mittlere Scangeschwindigkeit $v_{scan}$ des Yb:YAG/Scheibenlasers 210 und die dazu senkrecht gerichtete Transportgeschwindigkeit $v_{substrat}$ des Substratkörpers 2 sich überlagern, erzeugt der Laserstrahl 215 auf der Oberfläche des Substratkörpers 2 genaugenommen eine Zickzacklinie 250, wie in Fig. 11b zu sehen ist. Wenn die mittlere Scangeschwindigkeit $v_{scan}$ des Yb:YAG/- Scheibenlasers hinreichend groß gegenüber der Transportgeschwindigkeit $v_{substrat}$ des Substratkörpers ist, wird die Parkettierung deckend. Der Laserstrahl 215 scannt in der Zeit $T_s$ mit der mittleren Scangeschwindigkeit $v_{scan}$ die Breite $B$ in y-Richtung des Substratkörpers 2 bei der Hin und Her-Bewegung zweimal ab. Somit gilt $T_s = 2B/v_{scan}$

In dieser Zeit $T_s$, in der sich das Laserbeleuchtungsmodul 208 in y-Richtung einmal hin und her bewegt hat, muss sich der Substratkörper 2 in der x-Richtung gerade um die Länge $\Delta x$ des rechteckigen Laserfokus bewegt haben, damit die Parkettierung deckend wird:

$$\Delta x = v_{substrat} T_s = v_{substrat} 2B/v_{scan} .$$

Folglich gilt

$$v_{scan} = \frac{2B}{\Delta x} \cdot v_{substrat} .$$

Sind also die Geschwindigkeiten $v_{scan}$ und $v_{substrat}$ nach dieser Gleichung aufeinander abgestimmt, scannt das Laserbeleuchtungsmodul 208 die gesamte Oberfläche des Substratkörpers 2 zeilenweise deckend ab und kann damit die Beschichtung 3 des Substratkörpers 2 homogen erwärmen. Die Rechtecke überlappen sich allerdings dabei. Es ist aber auch denkbar, dass, solange das Laserbeleuchtungsmodul 208 eine Zeile des Substratkörpers 2 abscannt, die Transporteinrichtung 205 den Substratkörper 2 anhält und ihn nur zwischen den zeilenweisen Scans um die Einheit $\Delta x$ weiterbewegt. Somit wird eine Zickzackbewegung auf jeden Fall ausgeschlossen, und die Rechtecke überlappen sich nicht.

Im Folgenden wird ein erstes Ausführungsbeispiel des Verfahrens anhand der Figuren ausführlich beschrieben.

Ein Substrat 5, vorzugweise aus Glas, wird im Verfahrensschritt I mit einem leitfähigen, transparenten Metalloxid beschichtet, welches im Wesentlichen aus Zinkoxid, Cadmiumoxid, Zinnoxid, Indiumoxid oder aus Mischungen von zwei oder mehreren dieser Oxide besteht.

Beschichtet wird mit einer Beschichtungsvorrichtung 100, siehe Fig. 2, die das Metalloxid mittels physikalischer oder chemischer Gasphasenabscheidung in einem Vakuumprozess auf dem Substrat 5 abscheidet. Die Beschichtung wird bei kleinen Substrattemperaturen $T_l$ vorgenommen. Die Substrate 5 werden dabei bevorzugt während oder vor der Beschichtung nicht gesondert beheizt. Die Abscheidung der transparenten leitfähigen Schicht 2 erfolgt in einem Vakuumprozess mittels physikalischer Gasphasenabscheidung durch Sputtern oder reaktives Sputtern oder durch Verdampfen oder durch thermisches Verdampfen oder durch Elektronenstrahlverdampfen oder durch Laserstrahlverdampfen.

Die Abscheidung der transparenten leitfähigen Schicht 3 kann in einem Vakuumprozess auch chemisch oder speziell durch thermisch aktivierte chemische oder durch plasmaaktivierte chemische oder durch laseraktivierte Gasphasenabscheidung erfolgen. Auch kann bei der Abscheidung der transparenten leitfähigen Schicht 3 die chemische Gasphasenabscheidung oder die thermisch aktivierte chemische Gasphasenabscheidung in einzelnen, jeweils nur aus einer der konstituierenden Komponenten bestehenden und maximal eine Monolage umfassenden Teilschichten erfolgen.

Als dritte Möglichkeit kann die Abscheidung der transparenten leitfähigen Schicht(en) 3 nasschemisch, z.B. durch ein Sol-Gel Verfahren oder durch ein Druckverfahren erfolgen. Ausführlich beschrieben wird hier in diesem ersten Ausführungsbeispiel das Sputtern, wie in Fig. 2 gezeigt ist. Einem Festkörper 3', der aus einem transparenten, leitfähigen Metalloxid besteht, werden in einer Vakuumkammer 101 durch Beschuss mit energiereichen Ionen 109 Atome 110 herausgelöst. Diese Atome scheiden sich an der Oberfläche eines Substrats 5, das in einem Durchlaufverfahren mit konstanter Geschwindigkeit $v_l$ auf einer Transporteinrichtung 120 durch die Vakuumkammer 101 bewegt wird, ab.

Die Abscheidung der transparenten leitfähigen Schicht 3 erfolgt bevorzugt bei einer Substrattemperatur $T_l$, die höchstens 180°C, weiter bevorzugt höchstens 160°C, noch weiter bevorzugt höchstens 150°C, insbesondere bevorzugt höchstens 130°C beträgt. Der so mit der Beschichtung 3 beschichtete Substratkörper 2 verlässt auf der Transporteinrichtung 120 die Sputteranlage 100. Bevorzugt wird das Substrat nicht eigens vorgeheizt, sondern die Abscheidung erfolgt anfangs auf dem sich auf Raumtemperatur befindlichen Substrat. Durch das Beschichten erhöht sich die Temperatur des Substrats gleichmäßig, bis sich durch Konvektion und Abstrahlungsverluste ein thermisches Gleichgewicht einstellt. Im thermischen Gleichgewicht ergibt sich dann bevorzugt die vorstehend genannte Temperatur.

Im nächsten und wichtigsten Verfahrensschritt II zur Einstellung der elektrischen Leitfähigkeit und optischen Transmission wird das beschichtete Substrat 2 einer Temperaturbehandlung durch Laserbestrahlung, auch Lasertempern genannt, unterzogen. Die Beschichtung 3 wird durch das Lasertempern dabei auf eine Temperatur $T_{IIa}$ von z.B. 200°C erhitzt. Das Lasertempern erfolgt fast senkrecht zur ebenen Oberfläche der Beschichtung 3 des Substratkörpers 2. Wie in Fig. 4c gezeigt ist, ist der Laserstrahl gegen die Senkrechte der Oberfläche um einen kleinen Winkel $\delta$ geneigt, um die Laser 210 vor seinem eigenen emittierten Licht durch die Reflexion an der Beschichtung 3 zu schützen. Das von vielen Einzellasern 210 erzeugte Laserlicht wird durch Kollimatoren 220 und anschließend durch asphärische Linsen 231 geleitet.

Dabei bilden mindestens zwei Laser 210, ein Kollimator 220 mit Zylinderlinsen 221 und ein sogenanntes Mikrolinsenarray 230 mit asphärischen Linsen 231 je ein Laserbeleuchtungsmodul 208, wie es in der Figur 5a näher beschrieben ist. Die asphärischen Linsen 231 des Mikrolinsenarrays 230 fokussieren das durch die Kollimatoren 230 parallelisierte Laserlicht, so dass jeder einzelne Strahl einen Strahlkegel 240 erzeugt, der im Fokus einen elliptischen Querschnitt aufweist. Die langen Hauptachsen der Ellipse 251 dieser Strahlkegel 240 befinden sich alle auf einer geraden Linie, einer sogenannten Laserlinie 250. Die lineare Leitungsdichte $P_{lin}$ dieser Laserlinie 250 beträgt z.B. 450 Watt/cm.

Dabei überlappen sich diese Ellipsen 251 in Richtung ihrer längeren Halbachse, wie es in Fig. 5b dargestellt ist. Die Ellipsen 251, insbesondere die Länge der beiden kurzen Halbachsen, sind klein gegen die Länge der Laserlinie 250.

Das Verhältnis von der Länge zur Breite der Laserlinie 250, wobei die Breite durch die kurzen Halbachsen der Ellipsen 251 bestimmt ist, ist dabei vorteilhafterweise größer als 100. Somit kann eine starke Fokussierung erzielt werden.

Jedes einzelne Laserbeleuchtungsmodul 208 erzeugt eine Laserline 250. Um aber das beschichtete Substrat 2 in seiner ganzen Breite gleichmäßig zu bestrahlen, werden die Laserbeleuchtungsmodule 208 so ausgerichtet, dass sie eine gemeinsame Laserlinie 250 auf der Beschichtung 3 abbilden. Dabei können sich die einzelnen Beleuchtungsbereiche 208b, die jeweils von einem Laserbeleuchtungsmodul 208 erzeugt werden, zu einer gemeinsamen Laserlinie 250 überlappen, oder die einzelnen Beleuchtungsbereiche 208b sind in mehreren Streifen nebeneinander geordnet und bilden so eine gemeinsame Laserlinie 250.

Vorteilhaft wird dabei das Durchgangsverfahren angewendet, in dem das beschichtete Substrat 2 auf einer Transporteinrichtung 205 mit konstanter Geschwindigkeit $v_{IIa}$ geradlinig bewegt wird und die Laserbeleuchtungsmodule 208 stationär angeordnet sind. Die Substratbreite beträgt dabei zwischen 1m und 6m. Die Laserlinie 250 überstreicht die gesamte Breite des Substrats senkrecht zur Bewegungsrichtung, da die Beleuchtungsbereiche 208b entsprechend nebeneinander angeordnet sind.

Bei dieser erfindungsgemäßen Temperaturbehandlung durch Laserstrahlen werden ca. 10-20% der Strahlungsenergie des Laserlichts in die Schicht 3 eingekoppelt.

Das Tempern durch Laserbestrahlung erfolg bevorzugt in einem Wellenlängenbereich von 800nm bis 1200nm.

Beim Tempern durch Laserbestrahlung werden für das erfindungsgemäße Verfahren im Wellenlängenbereich von 800nm bis 1000nm bevorzugt Dioden-Laser insbesondere mit einer Wellenlänge von 808nm bzw. 950nm und im Wellenlängenbereich von 1000nm bis 1200nm Festkörperlaser eingesetzt. Für die Wellenlänge 950nm sind zum Beispiel InGaAs-Dioden-Laser geeignet. Laserdioden sind sehr klein und erfordern nur wenig Aufwand beim Betrieb. Eine nützliche Eigenschaft von Laserdioden ist ihre hohe Modulationsbandbreite. Durch Modulation des elektrischen Stromes, der durch die Diode fließt, kann man eine nahezu lineare Änderung der Ausgangsleistung erreichen. Diodenlaser sind die effizientesten Strahlungsquellen im nahen Infrarotbereich und haben Wirkungsgrade bis über 50%.

Betrachtet man das Reflexionsspektrum einer TCO-Schicht, so stellt man fest, dass an der Plasmakante, die definitionsgemäß eine charakteristische Struktur in einem Reflexionsspektrum ist, die Absorption mit steigender Wellenlänge zunimmt, die Eindringtiefe nimmt hingegen ab. Die Plasmakante tritt bei Festkörpern an der Stelle im Spektrum auf, wo die Plasmaresonanz auftritt. Dort weist der Realteil $\varepsilon 1$ der Dielektrizitätskonstanten eine Nullstelle auf. Bei $\varepsilon 1=1$ verschwindet die Reflexion. Bei ca. 1000nm ist die Absorption jedoch relativ gering. Um aber die Laserleistung effektiv zu nutzen, werden daher im Wellenlängenbereich von 1000nm bis 1200nm, insbesondere Nd:YAG-Laser oder Yb:YAG-Laser eingesetzt.

Ein Nd:YAG-Laser bzw. Yb:YAG-Laser ist ein Festkörperlaser, der als aktives Medium einen Neodym- bzw. einen Yttrium YAG-Kristall verwendet. Nd:YAG steht für Neodym-dotierter Yttrium-Aluminium-Granat-Laser. Der Nd:YAG-Laser emittiert im Infrarotbereich mit der Wellenlänge 1064 nm. Der Yb:YAG-Laser ist ein Ytterbiumdotierter Yttrium-Aluminium-Granat-Laser. Der Yb:YAG-Laser strahlt mit einer Wellenlänge von 1030 nm. Dieser Yb:YAG-Laser wird jedoch bevorzugt im gepulsten Scanmodus eingesetzt. Siehe dazu Figur 11a-c, welche eine alternative Laser-Temperaturbehandlung durch einen Yb:YAG-Laser beschreibt. Alternativ eignet sich auch ein Er:YAG-Laser, Ho-YAG-

Laser oder $CO_2$-Laser. Alle Laser können gepulst oder kontinuierlich betrieben werden. Die Festkörper können als Stab oder Scheibe oder als Faser ausgeführt sein.

Nach dem Lasertempern folgt der Verfahrensschritt III. Das inzwischen abgekühlte beschichtete Substrat 2 wird nun in einer Ätzvorrichtung 400 geätzt. Dazu ist der Ablauf der Ätzung in Fig. 8 dargestellt. Dieser optionale Ätzschritt III kann nur erfolgen, wenn die Dichte $\delta$ der Beschichtung 3 durch die Temperaturbehandlung II einen bestimmten Wert erlangt hat. Durch die Ätzung wird der dritte gewünschte Parameter eingestellt: Das optische Streuverhalten der Beschichtung 3. Dazu wird durch eine Behandlung bevorzugt mit verdünnter Salzsäure (0,1% bis 5%) eine bestimmte Oberflächentextur geätzt. Das Ätzen wird dabei bevorzugt in einem Durchlaufverfahren durchgeführt, bei dem die Ätzvorrichtung ortsfest ist und das beschichte Substrat 2 mit konstanter Geschwindigkeit $v_{III}$ durch diese Ätzvor-richtung 400 hindurch bewegt wird.

Im Folgenden wird ein Referenzbeispiel anhand der Figuren ausführlich beschrieben. In diesem Beispiel entspricht der Verfahrensschritt I dem aus dem ersten Ausführungsbeispiel, der hier nicht wiederholt beschrieben wird. Im Verfahrensschritt II dieses Beispiels ist die Temperaturbehandlungsvorrichtung ein Hochkonvektionsofen 300. In diesem Hochkonvektionsofen 300 wird das beschichtete Substrat 2 im Wesentlichen durch Konvektion gleichmäßig erhitzt, um die gewünschten beiden Parameter elektrische Leitfähigkeit und optische Transmission einzustellen.

Der Substratkörper 2, ein beschichtetes Glas, fährt auf einem Förderband 310 oder auf Walzrollen 310 mit konstanter Geschwindigkeit $v_{IIb}$ durch den Hochkonvektionsofen 300. Die durch Heizstrahler 320 erhitzte Luft heizt die Beschichtung 3 auf, kühlt durch die Wärmeübertragung auf die Beschichtung 3 deswegen etwas ab, wird durch Ventilatoren 330 nach oben gewirbelt, die auch dafür sorgen, dass neue heiße Luft auf die Beschichtung 3 zu nach unten gewirbelt wird. Siehe dazu die Figur 7.

Angetrieben durch Ventilatoren 330 wird die Konvektion so gleichmäßig in Gang gehalten, und somit wird die Beschichtung gleichmäßig erhitzt z.B. auf die Temperatur $T_{IIb}$ = 200°C. Die Ventilatoren 330 können dabei, wie in der Fig. 7 gezeigt ist, in Reihen entlang der Laufrichtung der Transporteinrichtung 310 angeordnet sein, wobei jeweils zwei benachbarte Ventilatoren 330 gegensinnig rotieren, so dass sich vorteilhaft die auf- und absteigenden Konvektionsströme sich jeweils gegenseitig verstärken. Die Wärmeübertragung geschieht dabei nicht nur durch Konvektion, also durch den Transport von Teilchen, sondern auch direkt durch Strahlung und durch Wärmeleitung durch das Substrat 5. Den größten Anteil an der Erwärmung der Beschichtung 3 hat dabei die Konvektion, wohingegen die Anteile von Strahlung und Wärmeleitung wesentlich geringer sind. Auf der Oberseite des Substratkörpers 2 wird ein Teil der Wärme von der Beschichtung durch Strahlung und Konvektion absorbiert, ein Teil der Strahlung und Konvektion wird reflektiert und ein Teil der Strahlung und Konvektion wird durchgelassen (Transmission). Auf der Unterseite des Substratkörpers 2 geht ein Teil der Wärme durch das Substrat 5 und erreicht so durch Wärmeleitung von unten die Beschichtung 3.

Wie anhand der Figuren 8 und 9 beschrieben, kann alternativ die Erhitzung des Substratkörpers 5 durch Strahlung und Konvektion auch in einem Zweikammerofen 350 durchgeführt werden. Im Zweikammeroffen 350 werden neben Heizstrahlern 320 auch Heißluftgebläse 360 eingesetzt, die den Substratkörper 2 durch Konvektion gleichmäßig aufheizen.

Ganz entscheidend für die beiden einzustellenden physikalischen Größen der elektrischen Leitfähigkeit und optischen Transmission sind die Temperatur $T_{IIb}$ und die Dauer $\Delta t_{IIb}$ der Temperaturbehandlung. Diesem Verfahrensschritt II kann sich ein Ätzschritt III anschließen, der im ersten Ausführungsbeispiel beschrieben ist.

Durch die Laserbestrahlung, wie sie im ersten Ausführungsbeispiel beschrieben worden ist, oder die Temperaturbehandlung in einem Hochkonvektionsofen bzw. Zweikammerofen, wie sie im zweiten Ausführungsbeispiel beschrieben ist, werden die elektrische und die optische Leitfähigkeit erheblich verbessert, wobei mit dem Lasertempern die besten Ergebnisse erzielt werden.

Man kann mit diesen beiden Temperaturbehandlungen (II) einen spezifischen Widerstand von $100\mu\Omega$cm bis $1.000\mu\Omega$cm, bevorzugt von $200\mu\Omega$cm bis $750\mu\Omega$cm, eine Elektronenkonzentration von $2\times10^{20}$cm$^{-3}$ bis $8\times10^{20}$cm$^{-3}$, sowie eine Ladungsträgerbeweglichkeit zwischen 10 cm$^2$/Vs und 75 cm$^2$/Vs, bevorzugt zwischen 20 cm$^2$/Vs und 45 cm$^2$/Vs erzielen.

Alle beschriebenen und/oder gezeichneten Merkmale können im Rahmen der Erfindung vorteilhaft miteinander kombiniert werden. Die Erfindung ist nicht auf die Ausführungsbeispiele beschränkt.

**Patentansprüche**

1. Verfahren zur Herstellung eines beschichteten Gegenstands (2) durch Abscheidung mindestens einer transparenten leitfähigen dotierten Metalloxidschicht (3), einem TCO (transparent conductive oxide) auf einem Substrat (5), umfassend die Abscheidung (I) ohne zusätzliche Aufheizung des Substrats vor Beginn der Abscheidung (I), wobei das Aufbringen der Beschichtung bei einer Substrattemperatur von höchstens 180°C vorgenommen wird, und eine anschließende Temperaturbehandlung (II) der Beschichtung (3) durch Laserbestrahlung,
   **dadurch gekennzeichnet,**

**dass** zur Erzeugung der Laserstrahlung Laser (210) in Form von Yb:YAG-Laser im Wellenlängenbereich von 1000nm bis 1200nm oder Er:YAG-Laser oder Ho:YAG-Laser eingesetzt werden.

2. Verfahren nach Anspruch 1,
**dadurch gekennzeichnet,**
**dass** die Temperaturbehandlung (II) an Umgebungsluft erfolgt.

3. Verfahren nach einem der Ansprüche 1 bis 2,
**dadurch gekennzeichnet,**
**dass** zur Erzeugung einer Laserlinie (250) mehrere gekoppelte Laser (210) benutzt werden.

4. Verfahren nach Anspruch 3,
**dadurch gekennzeichnet,**
**dass** entweder

mindestens zwei gekoppelte Laser (210) jeweils ein Laserbeleuchtungsmodul (208) bilden, das einen Beleuchtungsbereich (208b) erzeugt, und
**dass** sich die einzelnen Beleuchtungsbereiche (208b) zu einer gemeinsamen Laserlinie (250) überlappen oder dass die einzelnen Beleuchtungsbereiche (208b) in Streifen nebeneinander geordnet eine gemeinsame Laserlinie (250) bilden,
oder dass ein Laser (210) ein Laserbeleuchtungsmodul (208) bildet, das einen Beleuchtungsbereich (208b) erzeugt, der durch lineares hin- und her- Bewegen des Laserbeleuchtungsmoduls (208) senkrecht zur Bewegungsrichtung des Substratkörpers (2) auf diesem eine Laserlinie (250) bildet.

5. Verfahren nach einem der Ansprüche 1 bis 4,
**dadurch gekennzeichnet,**
**dass** die Temperaturbehandlung (II) in einem Durchlaufprozess erfolgt.

6. Verfahren nach einem der Ansprüche 1 bis 5,
**dadurch gekennzeichnet,**
**dass** zwischen Substrat (5) und leitfähiger Schicht (3) eine Diffusionssperre (4) eingefügt wird.

7. Verfahren nach einem der Ansprüche 1 bis 6,
**dadurch gekennzeichnet,**
**dass** zwischen Substrat (5) und leitfähiger Schicht (3) oder Substrat (5) und Diffusionssperre (4) eine optische Interferenzschicht (4a, 4b) eingefügt wird.

8. Verfahren nach einem der Ansprüche 1 bis 7,
**dadurch gekennzeichnet,**
**dass** die Diffusionssperre (4) selbst als optische Interferenzschicht (4a, 4b) ausgebildet wird.

9. Verfahren nach einem der Ansprüche 1 bis 8,
**dadurch gekennzeichnet,**
**dass** die Abscheidung (I) der transparenten leitfähigen Schicht (3) durch Sputtern oder durch Verdampfen, insbesondere durch thermisches Verdampfen oder durch Elektronenstrahlverdampfen oder durch Laserstrahlverdampfen, erfolgt.

10. Verfahren nach einem der Ansprüche 1 bis 9,
**dadurch gekennzeichnet,**
**dass** die Abscheidung (I) der transparenten leitfähigen Schicht (3) durch chemische, insbesondere durch thermisch aktivierte chemische Gasphasenabscheidung, erfolgt.

11. Verfahren nach Anspruch 10,
**dadurch gekennzeichnet,**
**dass** die Abscheidung (I) der transparenten leitfähigen Schicht (3) in einzelnen, jeweils nur aus einer der konstituierenden Komponenten bestehenden und maximal eine Monolage umfassenden Teilschichten erfolgt.

12. Verfahren nach Anspruch 10,

**dadurch gekennzeichnet,**
**dass** die Abscheidung (I) der transparenten leitfähigen Schicht (3) durch plasmaaktivierte chemische oder durch laseraktivierte chemische Gasphasenabscheidung erfolgt.

**13.** Verfahren nach einem der Ansprüche 1 bis 8,
**dadurch gekennzeichnet,**
**dass** die Abscheidung (I) der transparenten leitfähigen Schicht (3) durch ein Sol-Gel Verfahren oder durch ein Druckverfahren erfolgt.

**14.** Verfahren nach einem der Ansprüche 1 bis 13,
**dadurch gekennzeichnet,**
**dass** nach der Temperaturbehandlung (II) die Oberflächentextur (3b) der Beschichtung (3) durch ein Ätzverfahren (III) gezielt eingestellt wird und das Einstellen der Oberflächentextur (3b) durch einen Ätzschritt (III) in einem Durchlaufverfahren erfolgt.

**15.** Verfahren nach einem der Ansprüche 1 bis 14,
**dadurch gekennzeichnet,**
**dass** die Abscheidung der Metalloxidschicht (3) auf das Substrat (5) bei einer Temperatur des Substrats $T_I$ von höchstens 150°C, bevorzugt höchstens 130°C erfolgt.

**16.** System zur Herstellung eines beschichteten Gegenstands (2), wobei das System eine Vorrichtung (100) zur Abscheidung (I) mindestens einer transparenten leitfähigen dotierten Metalloxidschicht (3), einem TCO (transparent conductive oxide), ohne zusätzliche Aufheizung des Substrats vor Beginn der Abscheidung (I), wobei das Aufbringen der Beschichtung bei einer Substrattemperatur von höchstens 180°C vorgenommen wird, und zur Temperaturbehandlung (II) eine Laserbestrahlungsvorrichtung (200) aufweist,
**dadurch gekennzeichnet,**

**dass** die Laserbestrahlungsvorrichtung (200) Yb:YAG-Laser (210), die im Wellenlängenbereich von 1000nm bis 1200nm eingesetzt werden, oder Er:YAG-Laser oder Ho:YAG-Laser aufweist, und
**dass** die Laserbestrahlungsvorrichtung (200) mindestens eine Transporteinrichtung (205) und mindestens ein Laserbeleuchtungsmodul (208) aufweist, das mindestens zwei gekoppelte Laser (210) und eine optische Einheit, insbesondere einen Kollimator (220) mit Zylinderlinsen (221) und einem Mikrolinsenarray (230) mit asphärischen Linsen (231), umfasst.

**Claims**

**1.** Process for producing a coated object (2) by deposition of at least one transparent conductive doped metal oxide layer (3), a TCO (transparent conductive oxide) on a substrate (5), comprising the deposition (I) without additional heating of the substrate before commencement of the deposition (I), wherein the coating is applied at a substrate temperature of not more than 180°C, and a subsequent heat treatment (II) of the coating (3) by laser irradiation,
**characterized in that**
lasers (210) in the form of Yb:YAG lasers in the wavelength range from 1000nm to 1200nm or Er:YAG lasers or Ho:YAG lasers are used for producing the laser radiation.

**2.** Process according to claim 1,
**characterized in that**
the heat treatment (II) is carried out in ambient air.

**3.** Process according to either claim 1 or 2,
**characterized in that**
a plurality of coupled lasers (210) are used for producing a laser line (250).

**4.** Process according to claim 3,
**characterized in that**

either at least two coupled lasers (210) in each case form a laser illumination module (208) which produces an illumination region (208b), and

the individual illumination regions (208b) overlap to form a joint laser line (250) or the individual illumination regions (208b) arranged next to one another in strips form a joint laser line (250),
or a laser (210) forms a laser illumination module (208) which produces an illumination region (208b) which by linear back-and-forth movement of the laser illumination module (208) perpendicular to the direction of movement of the substrate body (2) forms a laser line (250) on the latter.

5. Process according to any of claims 1 to 4,
**characterized in that**
the heat treatment (II) is carried out in a through-passage process.

6. Process according to any of claims 1 to 5,
**characterized in that**
a diffusion barrier (4) is inserted between substrate (5) and conductive layer (3).

7. Process according to any of claims 1 to 6,
**characterized in that**
an optical interference layer (4a, 4b) is inserted between substrate (5) and conductive layer (3) or substrate (5) and diffusion barrier (4).

8. Process according to any of claims 1 to 7,
**characterized in that**
the diffusion barrier (4) is itself configured as optical interference layer (4a, 4b).

9. Process according to any of claims 1 to 8,
**characterized in that**
the deposition (I) of the transparent conductive layer (3) is carried out by sputtering or by vaporization, in particular by thermal vaporization or by electron beam vaporization or by laser beam vaporization.

10. Process according to any of claims 1 to 9,
**characterized in that**
the deposition (I) of the transparent conductive layer (3) is carried out by chemical vapour deposition, in particular by thermally activated chemical vapour deposition.

11. Process according to claim 10,
**characterized in that**
the deposition (I) of the transparent conductive layer (3) is carried out in individual sublayers, in each case consisting only of one of the constituent components and comprising not more than one monolayer.

12. Process according to claim 10,
**characterized in that**
the deposition (I) of the transparent conductive layer (3) is carried out by plasma-activated chemical vapour deposition or by laser-activated chemical vapour deposition.

13. Process according to any of claims 1 to 8,
**characterized in that**
the deposition (I) of the transparent conductive layer (3) is carried out by means of a sol-gel process or by means of a printing process.

14. Process according to any of claims 1 to 13,
**characterized in that,**
after the heat treatment (II), the surface texture (3b) of the coating (3) is set in a targeted manner by means of an etching process (III) and the setting of the surface texture (3b) is carried out by means of an etching step (III) in a through-passage process.

15. Process according to any of claims 1 to 14,
**characterized in that**
the deposition of the metal oxide layer (3) on the substrate (5) is carried out at a temperature of the substrate $T_I$ of not more than 150°C, preferably not more than 130°C.

**16.** System for producing a coated object (2), where the system has an apparatus (100) for the deposition (I) of at least one transparent conductive doped metal oxide layer (3), a TCO (transparent conductive oxide), without additional heating of the substrate before commencement of the deposition (I), wherein the coating is applied at a substrate temperature of not more than 180°C, and a laser irradiation apparatus (200) for the heat treatment (II), **characterized in that**

the laser irradiation apparatus (200) has Yb:YAG lasers (210) which are used in the wavelength range from 1000nm to 1200nm or Er:YAG lasers or Ho:YAG lasers, and
the laser irradiation apparatus (200) has at least one transport device (205) and at least one laser illumination module (208) which comprises at least two coupled lasers (210) and an optical unit, in particular a collimator (220) having cylindrical lenses (221) and a microlens array (230) having aspherical lenses (231).

**Revendications**

**1.** Procédé pour fabriquer un objet revêtu (2) par dépôt d'au moins une couche d'oxyde métallique dopée conductrice transparente (3), d'un TCO (transparent conductive oxide) sur un substrat (5), comprenant le dépôt (I) sans chauffage supplémentaire du substrat avant le début du dépôt (I), l'application du revêtement étant effectuée à une température de substrat d'au plus 180°C, et un traitement thermique subséquent (II) du revêtement (3) par irradiation laser, **caractérisé en ce que**
pour la production du rayonnement laser des lasers Yb:YAG dans le domaine de longueurs d'onde de 1000 nm à 1200 nm ou des lasers Er:YAG ou des lasers Ho:YAG sont utilisés.

**2.** Procédé selon la revendication 1, **caractérisé en ce que**
le traitement thermique (II) a lieu à l'air ambiant.

**3.** Procédé selon l'une des revendications 1 à 2, **caractérisé en ce que**
pour la production d'une ligne laser (250) plusieurs lasers (210) couplés sont utilisés.

**4.** Procédé selon la revendication 3, **caractérisé en ce que**

au moins deux lasers (210) couplés forment à chaque fois un module d'éclairage laser (208) qui produit un domaine d'éclairage (208b), et **en ce que** les différents domaines d'éclairage (208b) se chevauchent en une ligne laser commune (250) ou **en ce que** les différents domaines d'éclairage (208b) disposés les uns à côté des autres en bandes forment une ligne laser commune (250),
ou **en ce qu'**un laser (210) forme un module d'éclairage laser (208) qui produit un domaine d'éclairage (208b) qui forme par déplacement linéaire dans un sens et dans l'autre du module d'éclairage laser (208) perpendiculairement à la direction de déplacement du corps de substrat (2) une ligne laser (250) sur celui-ci.

**5.** Procédé selon l'une des revendications 1 à 4, **caractérisé en ce que**
le traitement thermique (II) a lieu dans un processus continu.

**6.** Procédé selon l'une des revendications 1 à 5, **caractérisé en ce que**
entre le substrat (5) et la couche conductrice (3) une barrière de diffusion (4) est insérée.

**7.** Procédé selon l'une des revendications 1 à 6, **caractérisé en ce que**
entre le substrat (5) et la couche conductrice (3) ou le substrat (5) et la barrière de diffusion (4) une couche d'interférence optique (4a, 4b) est insérée.

**8.** Procédé selon l'une des revendications 1 à 7 **caractérisé en ce que**
la barrière de diffusion (4) est agencée elle-même sous forme de couche d'interférence optique (4a, 4b).

**9.** Procédé selon l'une des revendications 1 à 8, **caractérisé en ce que**
le dépôt (I) de la couche conductrice transparente (3) a lieu par pulvérisation cathodique ou par évaporation, en particulier par évaporation thermique ou par évaporation par faisceau d'électrons ou par évaporation par faisceau laser.

**10.** Procédé selon l'une des revendications 1 à 9, **caractérisé en ce que**

le dépôt (I) de la couche conductrice transparente (3) a lieu par dépôt chimique en phase vapeur, en particulier par dépôt chimique en phase gazeuse activé thermiquement.

11. Procédé selon la revendication 10, **caractérisé en ce que**
le dépôt (I) de la couche conductrice transparente (3) a lieu en différentes couches partielles consistant chacune seulement en l'un des composants constitutifs et comprenant au maximum une monocouche.

12. Procédé selon la revendication 10, **caractérisé en ce que**
le dépôt (I) de la couche conductrice transparente (3) a lieu par dépôt chimique en phase vapeur activé par plasma ou par dépôt chimique en phase vapeur activé par laser.

13. Procédé selon l'une des revendications 1 à 8, **caractérisé en ce que**
le dépôt (I) de la couche conductrice transparente (3) a lieu par un procédé sol-gel ou par un procédé d'impression.

14. Procédé selon l'une des revendications 1 à 13, **caractérisé en ce que**
après le traitement thermique (II) la texture de surface (3b) du revêtement (3) est ajustée de manière ciblée par un procédé de gravure (III) et l'ajustement de la texture de surface (3b) a lieu par une étape de gravure (III) dans un procédé continu.

15. Procédé selon l'une des revendications 1 à 14, **caractérisé en ce que**
le dépôt de la couche d'oxyde métallique (3) sur le substrat (5) a lieu à une température du substrat $T_I$ d'au plus 150°C, de préférence encore d'au plus 130°C.

16. Système pour fabriquer un objet revêtu (2), où le système présente un dispositif (100) pour le dépôt (I) d'au moins une couche d'oxyde métallique dopée conductrice transparente (3), d'un TCO (transparent conductive oxide), sans chauffage supplémentaire du substrat avant le début du dépôt (I), l'application du revêtement étant effectuée à une température de substrat d'au plus 180°C, et comprenant un dispositif d'irradiation laser (200) pour le traitement thermique (II),
**caractérisé en ce que**

le dispositif d'irradiation laser (200) présente plusieurs lasers Yb:YAG (210), qui sont utilisés dans le domaine de longueurs d'onde de 1000 nm à 1200 nm, ou lasers Er:YAG ou lasers Ho:YAG, et
**en ce que** le dispositif d'irradiation laser (200) présente au moins un dispositif de transport (205) et au moins un module d'éclairage laser (208) qui comprend au moins deux lasers (210) couplés et une unité optique, en particulier un collimateur (220) avec des lentilles cylindriques (221) et une série de microlentilles (230) avec des lentilles asphériques (231).

Fig. 1

Fig. 2

Fig. 3

Fig. 4a

Fig. 4b

Fig. 4c

Fig. 5a

Fig. 5b

Fig. 6

Fig. 7

Fig. 8

EP 2 417 076 B2

Fig. 9

22

Fig. 10

Fig. 11a

Fig. 11b

Fig. 11c

**IN DER BESCHREIBUNG AUFGEFÜHRTE DOKUMENTE**

**In der Beschreibung aufgeführte Patentdokumente**

- WO 2007018975 A1
- WO 2008096089 A2

**In der Beschreibung aufgeführte Nicht-Patentliteratur**

- **IMAY H et al.** ULTRAVIOLET-LASER-INDUCED CRYSTALLIZATION OF SOL-GEL SCIENCE AND TECHNOLOGY. SPRINGER, 01 January 1998, vol. 12, 991-994